(19) Europäisches Patentamt
European Patent Office
Office européen des brevets

(11) **EP 3 506 437 A1**

(12) **EUROPEAN PATENT APPLICATION**
published in accordance with Art. 153(4) EPC

(43) Date of publication:
**03.07.2019   Bulletin 2019/27**

(51) Int Cl.:
***H01S 5/022*** (2006.01)      ***G02B 13/00*** (2006.01)

(21) Application number: **17843151.6**

(22) Date of filing: **07.06.2017**

(86) International application number:
**PCT/JP2017/021085**

(87) International publication number:
**WO 2018/037663 (01.03.2018 Gazette 2018/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **26.08.2016   JP 2016165360**

(71) Applicant: **Panasonic Intellectual Property Management Co., Ltd.**
**Osaka-shi, Osaka 540-6207 (JP)**

(72) Inventor: **ICHIHASHI, Kouki**
**Osaka 540-6207 (JP)**

(74) Representative: **Vigand, Philippe et al**
**Novagraaf International SA**
**Chemin de l'Echo 3**
**1213 Onex - Genève (CH)**

(54) **LASER MODULE**

(57)     The laser module of the present disclosure comprises the following structural elements:
a laser diode including a plurality of emitters arrayed along a first line, and emitting a laser beam from each one of the plurality of emitters at an emitting surface;
a first collimator lens disposed facing the emitting surface of the laser diode, and having positive power along a fast axis;
a beam twister disposed facing the laser beam given off from the first collimator lens, and turning the laser beam by approx. 90 degrees; and
an optical element disposed facing the laser beam given off from the beam twister, and including a plurality of incident surfaces placed in a stepped shape.
The laser module satisfies conditional expression (1) below for each of the incident surfaces of the optical element:

$$x^2 \leq \left(\frac{f}{w_0}\right)^2 \left(\frac{W^2}{16} - \left(\frac{\lambda f}{\pi w_0}\right)^2\right) \qquad (1)$$

where, x is a distance from the output surface of the beam twister to the incident surface of the optical element,
W is a width of the incident surface along the first line,
$\lambda$ is a wavelength of the laser beam,
f is a focal length of the fist collimator lens, and
w0 is a beam diameter of the laser beam along a line perpendicular to the first line, the beam diameter being measured at an output surface of each one of the emitters.

EP 3 506 437 A1

# FIG. 1

**Description**

**TECHNICAL FIELD**

The present disclosure relates to a laser module. More specifically the disclosure relates to a laser module to which a laser diode having multiple emitters is mounted.

**BACKGROUND ART**

In recent years, the laser machining market including such as a laser beam cutting or a laser beam welding has required a laser module employing a laser diode to output a laser beam of high power and high beam quality.

Patent literature 1 discloses a laser emitter module including a laser emitter bar having five emitters, a heat sink, a heat sink spacer, a fast axis collimator, a prism, and a beam conditioning optics. The laser emitter bar is rigidly mounted on the heat sink, which is fixed on the heat sink spacer. The fast axis collimator and the beam conditioning optics are fixed to the prism fixed on the heat sink spacer. The fast axis collimator collimates laser beams supplied from the emitters along the fast axis. The beam conditioning optics employs, for instance, a beam twister for turning an incident laser beam by approx. 90 degrees before giving off the laser beam.

The structure discussed above allows the fast axis collimator to collimate the laser beams along the fast axis, where the laser beam has a greater spread angle along the fast axis, and the laser beams can be turned by 90 degrees so that the fast axis can replace a slow axis.

Citation List

Patent Literature

PTL: Unexamined Japanese Patent Application Publication No. 2014 - 95916

**SUMMARY OF THE DISCLOSURE**

The present disclosure aims to provide a laser module that outputs laser beams of high power and improved beam quality.

The laser module of the present disclosure comprises the following structural elements:

a laser diode including a plurality of emitters arrayed along a first line, and emitting a laser beam from each one of the plurality of emitters at an emitting surface;
a first collimator lens disposed facing the emitting surface of the laser diode, and having positive power along a fast axis;
a beam twister disposed facing the laser beam given off from the first collimator lens, and turning the laser beam by approx. 90 degrees; and
an optical element disposed facing the laser beam given off from the beam twister, and including a plurality of incident surfaces placed in a stepped shape.

The laser module satisfies conditional expression (1) below for each of the incident surfaces of the optical element:

$$x^2 \leq \left( \frac{f}{w_0} \right)^2 \left( \frac{W^2}{16} - \left( \frac{\lambda f}{\pi w_0} \right)^2 \right) \qquad (1)$$

where, x is a distance from the output surface of the beam twister to the incident surface of the optical element,
W is a width of the incident surface along the first line,
$\lambda$ is a wavelength of the laser beam,
f is a focal length of the fist collimator lens, and
$w_0$ is a beam diameter of the laser beam along a line perpendicular to the first line, the beam diameter being measured at an output surface of each one of the emitters.

As discussed above, the laser module of the present disclosure can output laser beams of high power and improved beam quality.

**BRIEF DESCRIPTION OF DRAWINGS**

FIG. 1 is a perspective view showing a rough structure of laser module 1 in accordance with a first embodiment of the present disclosure.

FIG. 2 is a horizontal perspective view of laser module 1 in accordance with the first embodiment.

FIG. 3 is a front view of laser module 1 in accordance with the first embodiment.

FIG. 4 is an enlarged view of region A in FIG. 3.

FIG. 5 is a lateral view of laser module 1 in accordance with the first embodiment.

FIG. 6 is an enlarged view of region B in FIG. 5.

FIG. 7 is a perspective view of first collimator lens 50 in accordance with the first embodiment.

FIG. 8 is a sectional view cut along line 8 - 8 in FIG. 7.

FIG. 9 is a partial perspective view of beam twister 60 in accordance with the first embodiment.

FIG. 10 is a front view of beam twister 60 in accordance with the first embodiment.

FIG. 11 is a rear view of beam twister 60 in accordance with the first embodiment.

FIG. 12 is a perspective view of cylindrical lens 61 forming beam twister 60 in accordance with the first embodiment.

FIG. 13 is a perspective view showing a light path of the laser beam traveling through beam twister 60 in accordance with the first embodiment.

FIG. 14 is a lateral view showing the light path of the laser beam traveling through beam twister 60 in accordance with the first embodiment.

FIG. 15 is a plan view showing the light path of the laser beam traveling through beam twister 60 in accordance with the first embodiment.

FIG. 16 shows cascade-like (or step-like) mirror 80 of laser module 1 in accordance with the first embodiment.

FIG. 17 shows prism 90 of laser module 2 in accordance with a second embodiment of the present disclosure.

**DESCRIPTION OF EMBODIMENTS**

**FIRST EXEMPLARY EMBODIMENT**

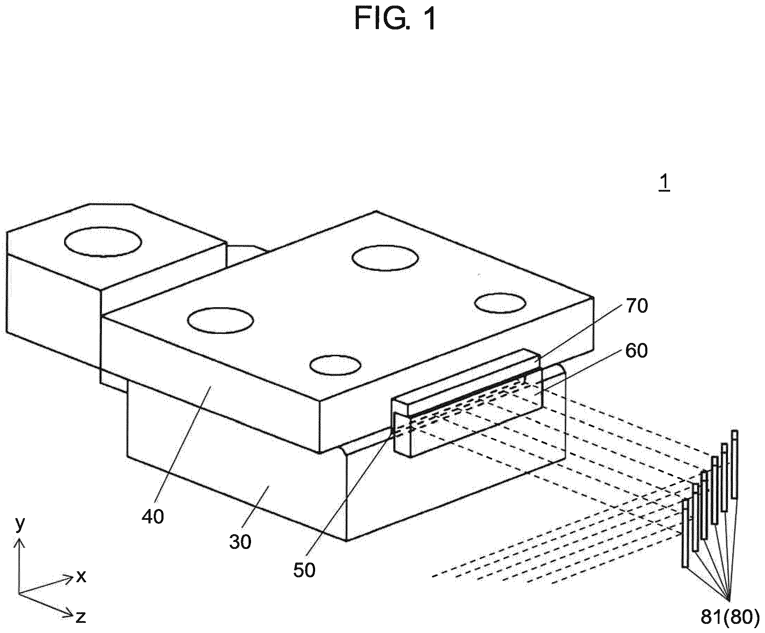

The exemplary embodiments of the present disclosure are demonstrated hereinafter with reference to FIG. 1 - FIG. 16.

**1 - 1. Laser Module**

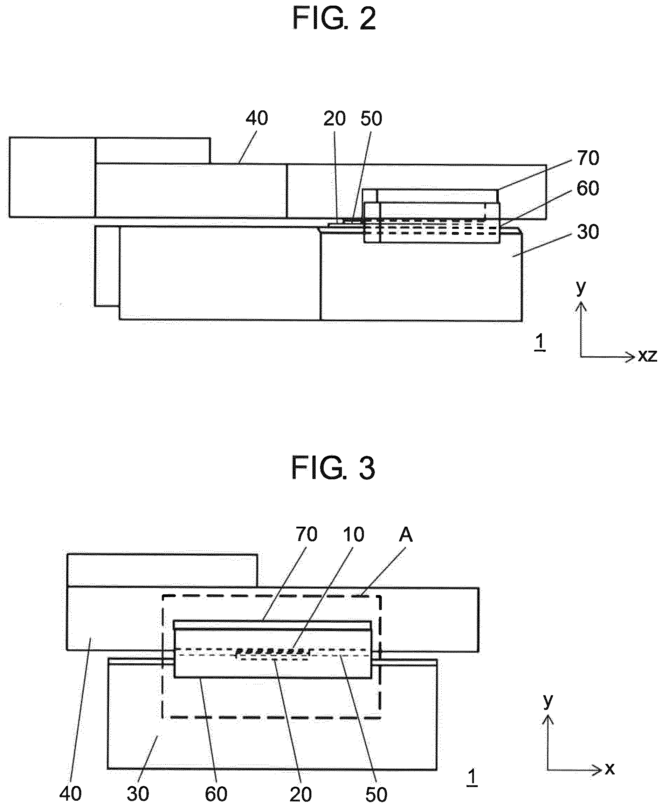

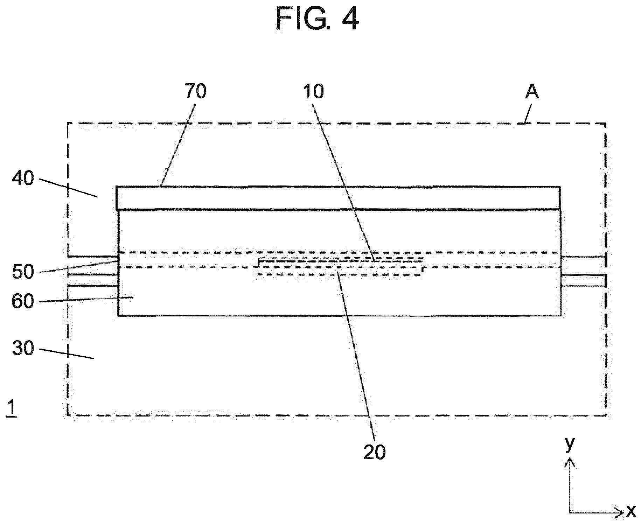

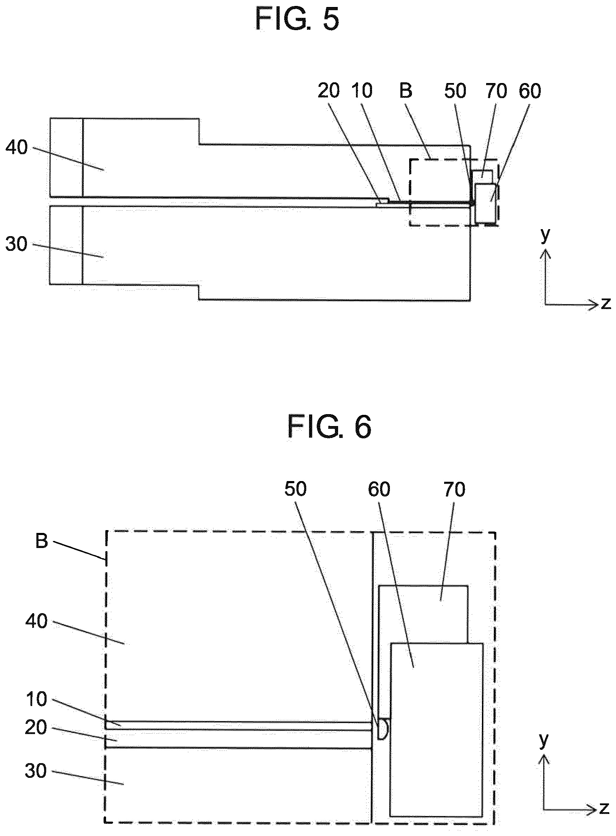

FIG. 1 is a perspective view illustrating a rough structure of laser module 1 in accordance with the first embodiment. FIG. 2 is a horizontal perspective view of laser module 1 in accordance with the first embodiment. FIG. 3 is a front view of laser module 1 in accordance with the first embodiment. FIG. 4 is an enlarged view of region A surrounded with broken lines in FIG. 3. FIG. 5 is a lateral view of laser module 1 in accordance with the first embodiment. FIG. 6 is an enlarged view of region B surrounded with broken lines in FIG. 5.

As FIG. 1 - FIG. 6 show, laser module 1 in accordance with the first embodiment comprises the following structural elements:

laser diode 10;
sub-mount 20;
lower electrode block 30;
upper electrode block 40;
first collimator lens 50;
beam twister 60;
pedestal 70; and
cascade-like (or step-like) mirror 80.

Laser diode 10 includes multiple emitters 11 which output laser beams, and is mounted to sub-mount 20. These elements are sandwiched by lower electrode block 30 and upper electrode block 40. Both blocks 30 and 40 work as electrodes for connecting laser diode 10 to a power supply (not shown), and also work as radiators for dissipating heat generated by laser diode 10.

The emitting surface of laser diode 10 is placed to be substantially flush with the lateral surfaces of lower electrode block 30 and upper electrode block 40 (this structure is illustrated in the front surfaces in FIG. 3 and FIG. 4, and right-end surfaces in FIG. 5 and FIG. 6). Multiple emitters 11 are arrayed on the emitting surface of laser diode 10, and a flow of electric current through laser diode 10 allows each one of emitters 11 to output a laser beam from the emitting surface. The emitting surface of emitters 11 of laser diode 10 and its opposite surface have undergone an end-surface machining in order for the laser beam to totally reflect.

As FIG. 6 shows, first collimator lens 50 (first collimator lens) is separated from and confronts the emitting surface of laser diode 10 by a space of a given distance (first distance). First collimator lens 50 collimates the laser beams spreading along the fast axis, the laser beams being supplied from laser diode 10. First collimator lens 50 includes a plane and a curved surface. In this first embodiment, lens 50 is disposed such that the plane surface faces to laser diode 10 and the curved surface faces to the opposite side of laser diode 10. Nevertheless, lens 50 can be placed such that the curved surface faces to laser diode 10 and the plane surface faces to the opposite side of laser diode 10.

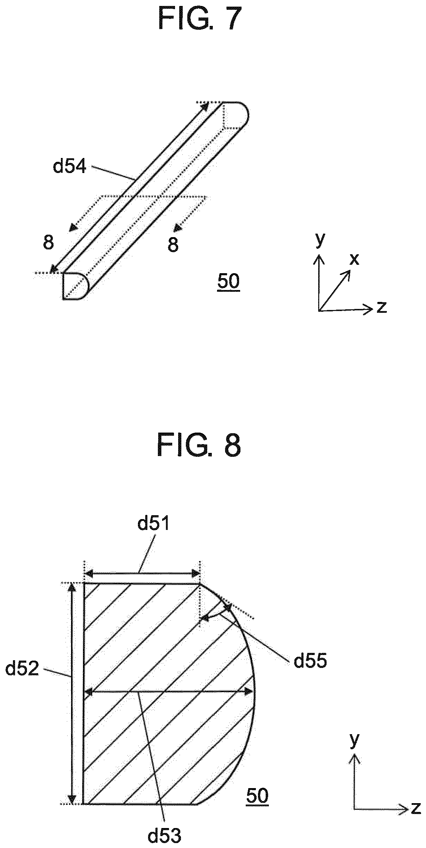

Lateral height d52 (refer to FIG. 8) of first collimator lens 50 is great enough to receive all the laser beams spreading along the fast axis. On top of that, lateral length d54 (refer to FIG. 7) of first collimator lens 50 is great enough to receive all the laser beams supplied from laser diode 10.

Beam twister 60 is disposed opposite to laser diode 10 with respect to first collimator lens 50 with a space of a given distance (second distance) from first collimator lens 50. Beam twister 60 turns the laser beams given off from first collimator lens 50 by about 90 degrees. First collimator lens 50 and beam twister 60 are rigidly mounted to pedestal 70 so that the positional relation between lens 50 and twister 60 can be specified. The laser beams at the emitting moment from first collimator lens 50 is not yet collimated in a slow direction of the laser beams, namely, the laser beams still keep spreading, so that beam twister 60 had better be positioned as close as possible to first collimator lens 50, and they can even touch together (distance = 0 $\mu$m). Nevertheless, a machining accuracy of multiple cylindrical lenses 61 of lens 50 should be taken into account, so that it is a realistic solution that lens 50 is spaced a little bit away from twister 60.

As FIG. 1 shows, cascade-like or step-like mirror 80 (an example of the optical element) is placed confronting an emitting surface of beam twister 60. Cascade-like mirror 80 is formed of multiple reflection mirrors 81. The number of reflection mirrors 81 is equal to that of emitters 11. Each one of reflection mirrors 81 is placed on an optical axis of a laser beam given off from each one of multiple emitters 11. Reflection mirrors 81 are arrayed cascade-wise (or step-wise) such that a space between each reflection light from each one of reflection mirrors 81 can be smaller than that of between each incident light.

As discussed above, the laser beam emitted from laser diode 10 is collimated, in the first place, by first collimator lens 50 along the fast axis, thereby preventing the laser beam from spreading along the fast axis. The laser beam given off from first collimator lens 50 is turned by beam twister 60, thereby minimizing an overlap between adjacent emitters and thus preventing the laser beam from spreading along the slow axis. Cascade-like mirror 80 allows narrowing the spaces between the laser beams, along the fast axis, given off from each one of emitters 11. This mechanism allows minimizing space intervals, along the arraying line of the laser beams, between the laser beams emitted from laser diode 10, without changing space intervals between each one of emitters 11 of laser diode 10. The foregoing structure allows laser module 1 to output laser beams of high beam quality and high power.

**1 - 2. First Collimator Lens 50**

Next, first collimator lens 50 is detailed hereinafter with reference to FIG. 7 and FIG. 8. FIG. 7 is a perspective view of first collimator lens 50 in accordance with the first embodiment. FIG. 8 is a sectional view cut along line 8 - 8 in FIG. 7.

As FIG. 7 and FIG. 8 show, first collimator lens 50 is a pillar-like optical member and has a convex on its one side. Assume that a perpendicular line (y axis) in FIG. 8 is a perpendicular line of first collimator lens 50, and a plane defined with a line (x axis) perpendicular to the sheet of FIG. 8 and the perpendicular line (y axis) is an xy plane. A plane being substantially in parallel with the xy plane is a lateral surface of first collimator lens 50. Assume that a left-light line (z axis) in FIG. 8 indicates a thickness of first collimator lens 50, and a middle of the upper surface and the lower surface is a center. The lateral surface length of first collimator lens 50 is thus a length of the line perpendicular to the sheet of FIG. 8.

In order for all the laser beams emitted from laser diode 10 to penetrate through fist collimator lens 50, the lateral surface length d54 of lens 50 is set longer than the width of laser diode 10 (the length of the arraying line of emitters 11). As FIG. 7 and FIG. 8 show, first collimator lens 50 has a top surface and an underside (both are planes of length d52 X width d51), both being substantially perpendicular to the lateral surface, and lens 50 also has a convex on the laser beam emitting surface. This convex is connected to the top surface and the underside at angle d55. Thickness d53 of first collimator lens 50 is a distance between the center of the convex and the lateral surface. Thickness d53 is greater than width d51, so that the convex protrudes toward the emitting direction of the laser beams. First collimator lens 50 forms a cylindrical shape, and has a curvature only along the fast axis of laser diode 10, and has no curvature along a longitudinal line of the lateral surface. In this first embodiment, first collimator lens 50 is disposed, as discussed previously, in front of the emitting surface of laser diode 10, and collimates the laser beams given off from emitters 11 of laser diode 10 along the fast axis.

**1 - 3. Beam Twister 60**

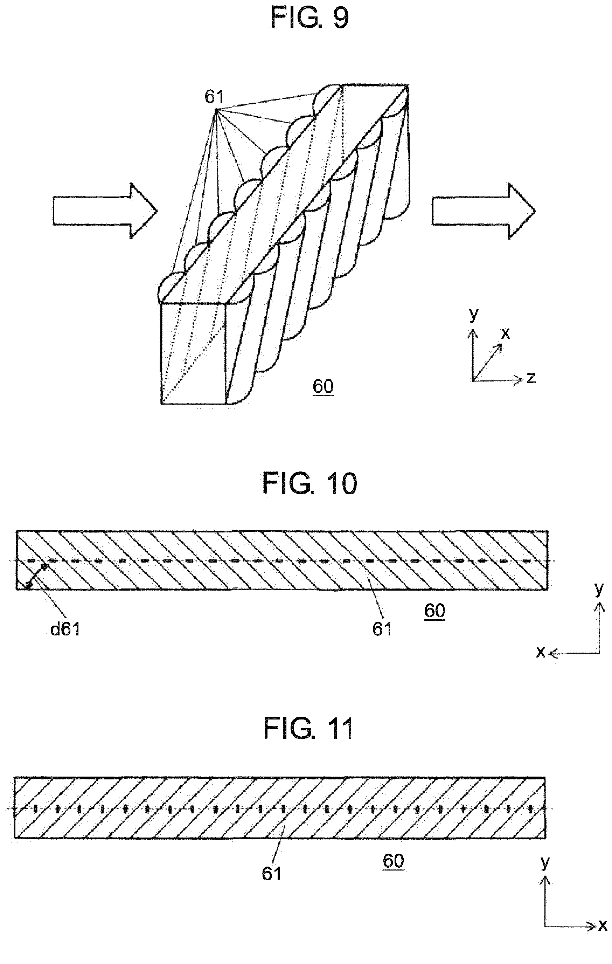

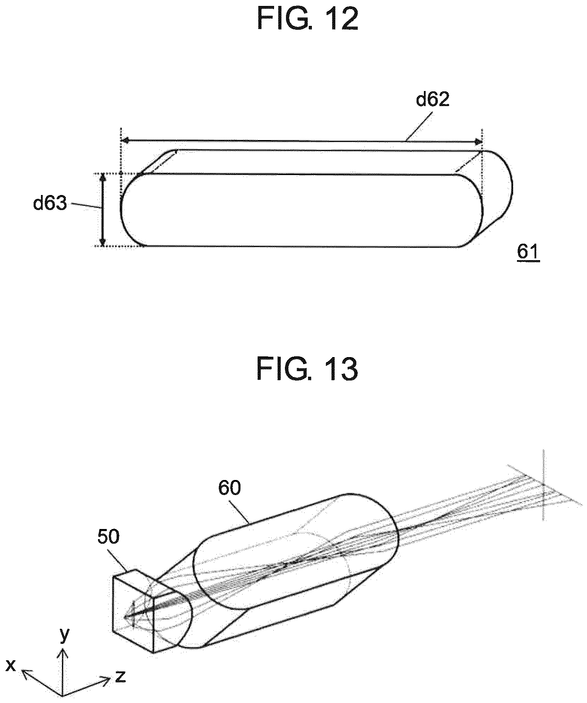

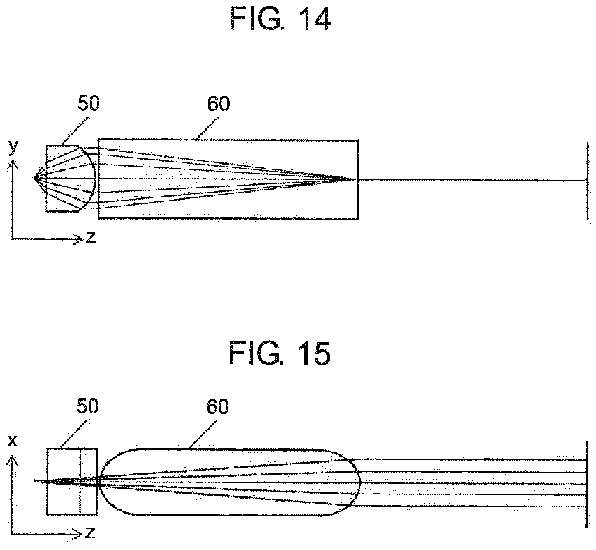

Beam twister 60 is detailed hereinafter with reference to FIG. 9 - FIG. 15. FIG. 9 is a partial perspective view of beam twister 60 in accordance with the first embodiment. FIG. 10 is a front view (showing an incident surface of the laser beams) of beam twister 60 in accordance with the first embodiment. FIG. 11 is a rear view (showing an output surface of the laser beams) of beam twister 60 in accordance with the first embodiment. FIG. 12 is a perspective view of cylindrical lens 61 forming beam twister 60 in accordance with the first embodiment. FIG. 13 is a perspective view showing a light path of the laser beams traveling through beam twister 60 in accordance with the first embodiment. FIG. 14 is a lateral view showing the light path of the laser beams traveling through beam twister 60 in accordance with the first embodiment. FIG. 15 is a plan view showing the light path of the laser beams traveling through beam twister 60 in accordance with the first embodiment.

As FIG. 9 - FIG. 11 show, beam twister 60 is formed of multiple cylindrical lenses 61 each of which forms a convex lens on both sides. Each of cylindrical lenses 61 is arrayed side by side with a slant angle d61, and forms an optical member. In this first embodiment, angle d61 is set to 45 degrees. As FIG. 10 and FIG. 11 show, this structure allows the laser beams having entered the front surface to slant by 90 degrees and then to emit from the rear surface. In other words, the fast axis of the laser beams can replace the slow axis. The arrow in FIG. 9 indicates a traveling direction of the laser beams. FIG. 10 shows beam twister 60 viewed from the left side in FIG. 9, and FIG. 11 shows beam twister 60 viewed from the right side in FIG. 9.

As FIG. 12 shows, in this first embodiment, thickness d61 of cylindrical lens 61 along a perpendicular line to the emitting surface of laser diode 10 is 1.55 mm, and height d63 of the lateral surface thereof is 0.2121 mm. A curvature radius of cylindrical lens 61 is 0.352 mm, and a refractive index thereof is 1.85280. The lateral surfaces of cylindrical lens 61 refer to an incident surface and an output surface of the laser beams. Height d63 of the lateral surface refers to the length of cylindrical lens 61 along the line perpendicular to the sheet of FIG. 12. The curved surfaces of cylindrical lenses 61 work as the incident surface and the output surface of the laser beams.

As FIG. 13 - FIG. 15 show, beam twister 60 formed of multiple cylindrical lenses 61 slanted by 45 degrees allows the laser beams entering the front surface (the surface confronting first collimator lens 50) to travel through beam twister 60 while being refracted as if to be turned, and turns by 90 degrees before emitting from the rear surface (opposite to the front surface). This mechanism allows the fast axis of the laser beams to replace the slow axis in position. The laser beam has been collimated along the fast axis; however, it still spreads along the slow axis.

**1 - 4. Cascade-like or Step-like Mirror**

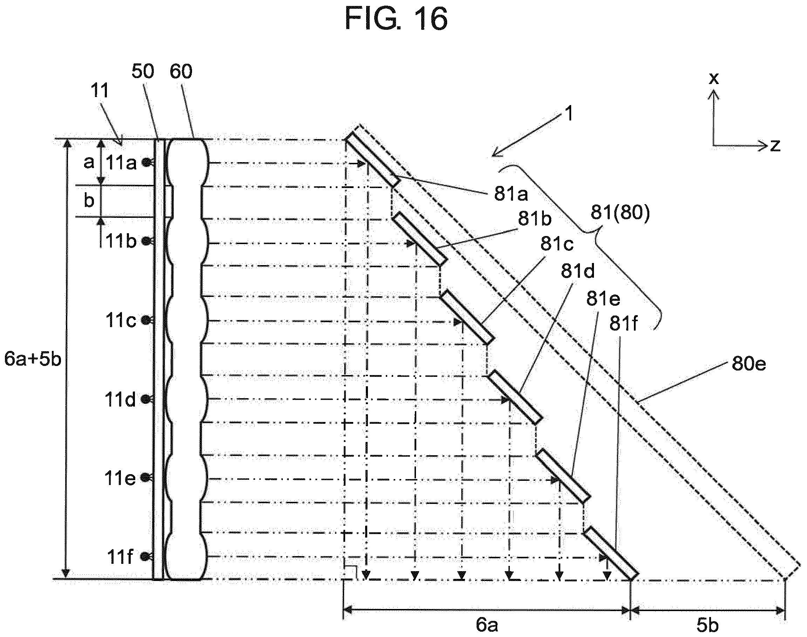

Cascade-like mirror 80 in accordance with the first embodiment is detailed hereinafter with reference to FIG. 16. The space intervals between each one of the laser beams given off from respective emitters 11 of laser diode 10 are narrowed by cascade-like mirror 80 without changing a spreading angle.

Cascade-like mirror 80 is formed of multiple reflection mirrors 81, and the number of reflection mirrors 81 is equal to the number of emitters 11 that form laser module 1. In FIG. 6, six emitters 11a - 11f and their counterparts' six reflection mirrors 81a - 81f are shown. Reflection mirrors 81 are arrayed cascade-wise with a slant angle of 45 degrees with respect to the optical axis of laser module 1. Respective reflection mirrors 81 are arrayed such that their space intervals can be narrower than those of respective incident beams. In other words, respective reflection mirrors 81 are arrayed along the optical axis (z axis) of the output beams given off from laser diode 10 with tight space intervals. The cascade-like array of reflection mirrors 81 allows preventing light beams of reflection light from entering another reflection mirror 81 and also narrowing space intervals between each one of the reflected light.

The theory of how the space intervals between each one of the laser beams are narrowed by cascade-like mirror 80 along the arraying line of the laser beams is described hereinafter. The laser beams given off from emitters 11 travel through first collimator lens 50 and beam twister 60, and then let's assume that the laser beams travel in parallel with each other. Six emitters 11 are used here for the convenience of description, nevertheless, the number of emitters 11 is not limited to this example.

As FIG. 16 shows, after the laser beams travel through beam twister 60, assume that a beam width is a, and a space interval between each one of the laser beams is b. Then a total width of the entire laser beams is 6a + 5b. Assume that these laser beams reflect from one sheet of reflection mirror 80e, the reflected laser beams have a width of 6a + 5b. Nevertheless, each one of reflection mirror 81 is arrayed cascade-wise with a tight space interval along z-axis in this first embodiment, so that width d is deleted from the width of each one of the laser beams. The width of the laser beams reflected from cascade-like mirror 80 thus becomes 6a. To be more specific, assume that an incident surface of reflection mirror 81a is disposed at the same place as an incident surface of reflection mirror 80e, then reflection mirror 81b is to be positioned closer to beam twister 60 by space interval b from reflection mirror 80e. In a similar manner, reflection mirrors 81c - 81f are positioned closer to beam twister 60 by space intervals 2b, 3b, 4b, and 5b from reflection mirror 80e.

Actually the laser beams cannot travel perfectly in parallel with each other due to diffraction, so that the laser beams have some spreads. To avoid the interference of the laser beam reflected by reflection mirror 81 with adjacent reflection mirror 81, the positions of each one of reflection mirrors 81 thus should be adjusted along the z-axis. To be more specific, reflection mirror 81a positioned upper most in FIG. 16 is referenced, then a moving amount of upper most reflection mirror 81 is 0 (zero), and a moving amount of second upper most reflection mirror 81 is c smaller enough than space interval b between each one of the laser beams. A moving amount of third upper most reflection mirror 81 is 2c, that of fourth upper most reflection mirror 81 is 3c, that of fifth upper most reflection mirror 81 is 4c, and that of sixth upper most reflection mirror 81 is 5c. As a result, the width of the laser beams reflected from cascade-like mirror 80 is 6a + 5c.

Next, the position of cascade-like mirror 80 (i.e. a distance along the z-axis from beam twister 60 to reflection mirror 81) is described hereinafter. Distance x from the output surface of beam twister 60 to the incident surface of cascade-like mirror 80 (reflection mirror 81) desirably satisfies condition (1) below:

$$x^2 \leq \left(\frac{f}{w_0}\right)^2 \left(\frac{W^2}{16} - \left(\frac{\lambda f}{\pi w_0}\right)^2\right) \qquad (1)$$

where, x is a distance from the output surface of beam twister 60 to the incident surface of cascade-like mirror 80 (reflection mirror 81);

W is a width of the incident surface of reflection mirror 81 along a first line;

$\lambda$ is a wavelength of the laser beam;

f is a focal length of first collimator lens 50; and

$w_0$: is a beam diameter of the laser beam along the fast axis (y-axis) at the output surface of emitter 11.

Satisfaction of condition (1) allows reducing an amount of the laser beam entering the adjacent reflection mirror 81 due to diffraction, while narrowing the space intervals between each one of the laser beams.

A calculation of condition (1) is demonstrated hereinafter. In laser module 1, a relation between width W along the x-axis (the first line) of the incident surface of reflection mirror 81 and beam diameter w (x) along the x-axis of the laser beam entering reflection mirror 81 desirably satisfies condition (2) below. Since the laser beam traveling along the fast axis is a basic mode, satisfaction of condition (2) will reduce an amount of the laser beam, entering the adjacent reflection mirror 81 caused by diffraction, to less than 5%.

$$\frac{W}{2} > 2w(x) \qquad (2)$$

where, beam diameter w (x) is a function of distance x from the output surface of beam twister 60, and since the laser beam traveling along the fast axis is the basic mode, use of a propagation expression of Gaussian beam's basic mode allows expressing the beam diameter in equation (3) below:

$$w^2(x) = w_1^2 \left[1 + \left(\frac{\lambda x}{\pi w_1^2}\right)^2\right] \qquad (3)$$

Beam diameter w1 of the laser beam along the x-axis at the output surface of beam twister 60 can be expressed in equation (4) below:

$$w_1 = \frac{\lambda f}{\pi w_0} \qquad (4)$$

Substitution of equations (3) and (4) for condition (2), and simplification of distance x will find condition (1) discussed previously.

**1 - 5. Advantage**

Beam quality of the laser beams given off from emitters 11 arrayed along the slow axis is described hereinafter. The beam quality along the arraying line is proportional to the product of the number of emitters 11, beam quality of each one of emitters 11, and a filling factor. The filling factor can be found from this division: space interval between emitters / width of emitter. It is desirable to narrow the space interval between emitters for improving the beam quality. Nevertheless, the narrower space intervals will invite greater thermal interference between the emitters, thereby causing a temperature rise at a welded section by the laser beam. This temperature rise invites carrier leak from an active layer or gain reduction due to increment in non-radiative recombination. As a result, an output of the laser beam can be reduced.

Laser module 1 according to the present disclosure allows the fast axis of the laser beam given off therefrom to agree with the arraying line of emitters 11, whereby the beam quality along the arraying line of emitters 11 can be improved. The presence of cascade-like mirror 80 allows narrowing the space intervals between each one of the laser beams, so that the reduction in the laser-beam output discussed above can be avoided, and yet, the beam quality along the arraying line of emitters 11 can be improved. On top of that, the space intervals between each one of the laser beams are narrowed with the intervals between each one of emitters 11 being kept wide. This structure allows preventing the laser beam given off from adjacent emitter 11 from entering cylindrical lens 61 of beam twister 60 in the case of narrower intervals between emitters 11.

Each one of reflection mirrors 81 is arrayed such that the space intervals between each reflection light from each reflection mirror 81 can be narrower. This structure allows narrowing the space intervals between each one of the laser beams, thereby to generate the laser beam as a whole with a narrow width. In the case of using the laser beam in a fiber-coupler type laser machining device, a coupling efficiency to optical fiber can be improved.

In the case of using laser module 1 in a laser oscillation device employing a resonator, the presence of laser module 1 allows downsizing the resonator, and yet, improving the beam quality. As a result, an optical loss in the resonator can be reduced, and an oscillation efficiency can be improved.

**SECOND EMBODIMENT**

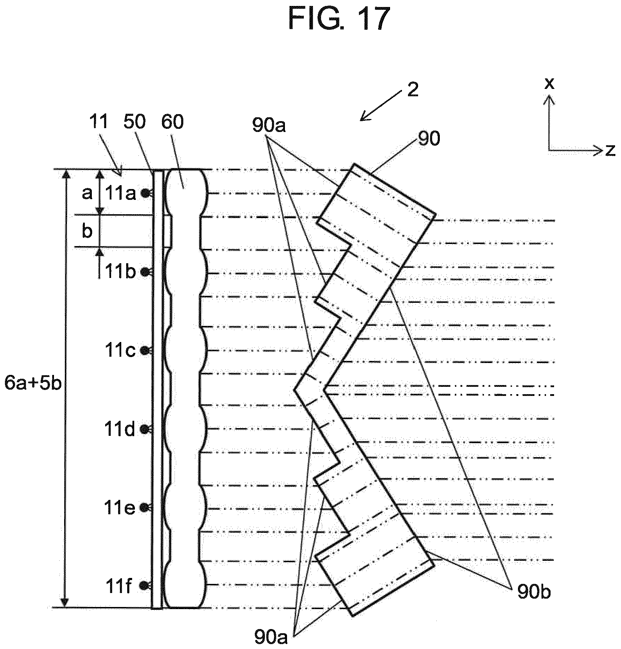

Laser module 2 in accordance with the second embodiment is demonstrated hereinafter with reference to FIG. 17. This second embodiment differs from the first embodiment in employing prism 90 as an optical element instead of cascade-like mirror 80. Descriptions of structural elements similar to those in the first embodiment are sometimes omitted here.

Prism 90 in accordance with the second embodiment has incident surface 90a and output surface 90b, and is disposed facing to the output surface of beam twister 60. Incident light to prism 90 emits therefrom shifting along the arraying line of multiple emitters 11 (e.g. 6 emitters 11a - 11f in FIG. 17). Prism 90 has multiple incident surfaces 90a corresponding to each one of emitters 11. Incident surfaces 90a slant with respect to the optical axis of an output light from beam twister 60, and are arrayed step-wise. Output surface 90b is formed on the flush plane with respect to the laser beams given off from multiple emitters 11. Incident surfaces 90a are in parallel with output surface 90b. A laser beam shifting in prism 90, by means of refraction, a longer length travels a longer distance in prism 90.

In laser module 2 in accordance with the second embodiment, six emitters (11a - 11f) is divided into two blocks (i.e. emitters 11a - 11c, and emitters 11d - 11f) as shown in FIG. 17. Incident surfaces 90a are formed step-wise corresponding to respective blocks. Output surface 90b is formed on the flush plane in each block (i.e. the output surface is formed in a plane shape). As a result, prism 90 is formed plane symmetrically with respect to a plane perpendicular to the x-axis. The plane symmetric shape of prism 90 allows downsizing the shape thereof along the z-axis.

The example shown in FIG. 17 illustrates that incident surfaces 90a are formed step-wise and each one of output surfaces 90b is formed on the flush plane (i.e. each one of output surfaces 90b is formed in a plane shape); nevertheless, output surfaces 90b can be formed step-wise and each one of incident surfaces 90a can be formed on the flush plane.

It is not necessarily to divide emitters 11 into two blocks, and incident surfaces 90a can be formed step-wise corresponding to the whole 6 emitters 11 and output surfaces 90b can be formed on the flush plane, and vice versa. In this case, the prism cannot be formed plane symmetrically, so that the shape thereof is obliged to be greater along the z-axis than prism 90.

The laser beam passing through incident surface 90a shifts toward the x-axis by a given amount. The maximum given amount of each laser beam given off respective emitters in this second embodiment is this:

laser beams given off from emitters 11a and 11f shift 5/2 b;
laser beams given off from emitters 11b and 11e shift 3/2 b; and
laser beams given off from emitters 11c and 11d shift 1/2 b.

The laser beams given off from emitters 11a - 11c shift in opposite direction to those from emitters 11d - 11f. The shift amount can be found by equations (5) and (6) below. Actually, the diffraction of the laser beams should be taken into account, so that the shift amount can be set a little bit smaller than the foregoing ones.

$$\mathrm{xs} = \mathrm{l}\sin(\theta - \alpha) \qquad (5)$$

$$\alpha = \sin^{-1}(1/n\sin(\theta)) \qquad (6)$$

where, xs is a shift amount,
1 is a length of optical path of each one of the laser beams traveling through the prism,
n is a refractive index,
$\theta$ is an incident angle of the laser beam entering the prism, and
$\alpha$ is a refraction angle of the laser beam entering the prism.

Use of the foregoing equations allows determining prism length 1, refractive index n, and incident angle $\theta$ with respect to a desirable shit amount.

Distance x along the z-axis from beam twister 60 to the incident surface of prism 90 can be defined by condition (1) discussed in the first embodiment about laser module 1, so that the description of the condition of distance x is omitted here.

Laser module 2 including prism 90 in accordance with the second embodiment allows narrowing the space intervals between each one of the laser beams without adjusting the space intervals between each one of the emitters. As a result, the beam quality of the laser beams along the arraying line of emitters 11 can be improved, and yet, a reduction in output of the laser beams can be prevented. On top of that, the space intervals between each one of the laser beams are narrowed with the intervals between each one of emitters 11 being kept wide, and in the case of narrower intervals between emitters 11, this structure allows preventing the laser beam given off from adjacent emitter 11 from entering cylindrical lens 61 of beam twister 60.

Laser module 2 including prism 90 in accordance with the second embodiment allows narrowing the space intervals between each one of the laser beams given off from prism 90 without adjusting the space intervals between each one of emitters 11 while the vector of the output light from prism 90 is kept the same as the vector of the output light from beam twister 60.

## INDUSTRIAL APPLICABILITY

The laser module disclosed here is applicable to a laser machining device requiring a high output and a high quality. The laser machining device includes such as a laser cutting device, or a laser welding machine. The laser module is also applicable to a light source of a projector requiring a high luminance.

## DESCRIPTIONS OF REFFERENCE MARKS

1, 2    laser module
10     laser diode
11     emitter
20     sub-mount
30     lower electrode block
40     upper electrode block

| 50 | first collimator lens |
|---|---|
| 60 | beam twister |
| 61 | cylindrical lens |
| 70 | pedestal |
| 80 | cascade-like mirror (an example of optical element) |
| 81 | reflection mirror |
| 80e | reflection mirror |
| 90 | prism (an example of optical element) |

**Claims**

1. A laser module comprising:

   a laser diode including a plurality of emitters arrayed along a first line, and emitting a laser beam from each one of the plurality of emitters at an emitting surface;
   a first collimator lens disposed facing the emitting surface of the laser diode, and having positive power along a fast axis;
   a beam twister disposed facing the laser beam given off from the first collimator lens, and turning the laser beam by approx. 90 degrees; and
   an optical element disposed facing the laser beam given off from the beam twister, and including a plurality of incident surfaces placed in a stepped shape,
   the laser module satisfying conditional expression (1) below for each of the incident surfaces of the optical element:

$$x^2 \leq \left(\frac{f}{w_0}\right)^2 \left(\frac{W^2}{16} - \left(\frac{\lambda f}{\pi w_0}\right)^2\right) \tag{1}$$

   where, x is a distance from an output surface of the beam twister to the incident surface of the optical element,
   W is a width of the incident surface along the first line,
   $\lambda$ is a wavelength of the laser beam,
   f is a focal length of the first collimator lens, and
   w0 is a beam diameter of the laser beam along a line perpendicular to the first line, the beam diameter being measured at an output surface of each one of the emitters.

2. The laser module according to claim 1, wherein the plurality of incident surfaces correspond to the plurality of emitters respectively.

3. The laser module according to claim 1, wherein each one of the plurality of incident surfaces of the optical element is a mirror surface.

4. The laser module according to claim 1, wherein the optical element is a prism having output surfaces, giving off laser beams having entered the plurality of incident surfaces, the output surfaces being flush with each other.

5. A laser module comprising:

   a laser diode including a plurality of emitters arrayed along a first line, and emitting a laser beam from each one of the plurality of emitters at an emitting surface;
   a first collimator lens disposed facing the emitting surface of the laser diode and having positive power along a fast axis;
   a beam twister disposed facing the laser beam given off from the first collimator lens, and turning the laser beam by about 90 degrees; and
   a prism disposed facing the laser beam given off from the beam twister, and having one of a plurality of incident surfaces placed in a stepped shape or a plurality of output surfaces placed in a stepped shape.

6. The laser module according to claim 5, wherein the prism has the plurality of incident surfaces placed in the stepped shape and the output surfaces giving off the laser beam having entered the plurality of incident surfaces, the output surfaces being flush with each other.

7. The laser module according to claim 5, wherein the prism includes:

   incident surfaces being flush with each other; and
   the plurality of output faces placed in the stepped shape, the plurality of output surfaces giving off the laser beam having entered the incident surfaces being flush with each other.

8. The laser module according to any one of claims 4 to 7, wherein the prism has a plane-symmetric shape with respect to a plane perpendicular to the first line.

# FIG. 1

EP 3 506 437 A1

# FIG. 2

# FIG. 3

# FIG. 4

# FIG. 5

20 10   B   50 70 60

40

30

y
z

# FIG. 6

50   60   70

B

40

10
20

30

y
z

# FIG. 7

d54

8          8

50

# FIG. 8

d51

d52          d55

d53          50

# FIG. 9

60

# FIG. 10

d61

61

60

# FIG. 11

61

60

## FIG. 12

## FIG. 13

## FIG. 14

## FIG. 15

# FIG. 16

# FIG. 17

EP 3 506 437 A1

## INTERNATIONAL SEARCH REPORT

International application No.

PCT/JP2017/021085

| A. CLASSIFICATION OF SUBJECT MATTER |
|---|
| *H01S5/022*(2006.01)i, *G02B13/00*(2006.01)i |

According to International Patent Classification (IPC) or to both national classification and IPC

| B. FIELDS SEARCHED |
|---|
| Minimum documentation searched (classification system followed by classification symbols)<br>H01S5/00-5/50, G02B13/00 |
| Documentation searched other than minimum documentation to the extent that such documents are included in the fields searched<br>Jitsuyo Shinan Koho        1922–1996   Jitsuyo Shinan Toroku Koho   1996–2017<br>Kokai Jitsuyo Shinan Koho   1971–2017   Toroku Jitsuyo Shinan Koho   1994–2017 |
| Electronic data base consulted during the international search (name of data base and, where practicable, search terms used) |

C. DOCUMENTS CONSIDERED TO BE RELEVANT

| Category* | Citation of document, with indication, where appropriate, of the relevant passages | Relevant to claim No. |
|---|---|---|
| Y | WO 2016/063436 A1  (Panasonic Intellectual Property Management Co., Ltd.), 28 April 2016 (28.04.2016), paragraphs [0013] to [0023]; fig. 1 to 15 & CN 106797102 A | 1-8 |
| Y | US 6240116 B1  (SDL, INC.), 29 May 2001 (29.05.2001), column 3, line 66 to column 6, line 11; fig. 1 to 4 (Family: none) | 1-8 |
| Y | JP 2006-337594 A  (Ricoh Optical Industries Co., Ltd.), 14 December 2006 (14.12.2006), paragraphs [0066] to [0083]; fig. 4 to 5 (Family: none) | 4-8 |

| [×] Further documents are listed in the continuation of Box C. | [ ] See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>10 August 2017 (10.08.17) | Date of mailing of the international search report<br>22 August 2017 (22.08.17) |
|---|---|
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**INTERNATIONAL SEARCH REPORT**

| International application No. |
| --- |
| PCT/JP2017/021085 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2015-72956 A  (Shimadzu Corp.),<br>16 April 2015 (16.04.2015),<br>paragraphs [0009] to [0052]; fig. 1 to 14<br>(Family: none) | 1-8 |
| A | JP 2011-520292 A  (Oclaro Photonics, Inc.),<br>14 July 2011 (14.07.2011),<br>paragraphs [0014] to [0046]; fig. 1 to 16<br>& US 2011/0103056 A1<br>paragraphs [0046] to [0077]; fig. 1 to 16<br>& WO 2009/137703 A2     & CN 102089943 A | 1-8 |
| A | JP 2004-252428 A  (Fuji Photo Film Co., Ltd.),<br>09 September 2004 (09.09.2004),<br>paragraphs [0034] to [0189]; fig. 1 to 27<br>& US 2004/0252388 A1<br>paragraphs [0093] to [0261]; fig. 1 to 27<br>& CN 1521963 A           & KR 10-1047357 B1 | 1-8 |
| A | JP 2004-96092 A  (Nippon Steel Corp.),<br>25 March 2004 (25.03.2004),<br>paragraphs [0094] to [0287]; fig. 7 to 85<br>& US 2005/0063435 A1<br>paragraphs [0158] to [0237]; fig. 3 to 85 | 1-8 |

Form PCT/ISA/210 (continuation of second sheet) (January 2015)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014095916 A